# EUROPEAN PATENT SPECIFICATION

(11) **EP 0 398 690 B1**
(45) Date of publication and mention of the grant of the patent: **25.09.1996**
(21) Application number: 90305301.5
(22) Date of filing: 16.05.1990
(51) Int. Cl.: H03M 13/12

(54) **Circuitry implementing the Viterbi algorithm**
Schaltung zur Durchführung des Viterbi Algorithmus
Circuit pour mettre en oeuvre l'algorithme de Viterbi

(30) Priority: 17.05.1989 FI 892370
(43) Date of publication of application: 22.11.1990
(73) Proprietor: NOKIA MOBILE PHONES LTD., 24101 Salo (FI)
(72) Inventor: Silander, Jussi, SF-24800 Halikko (FI)
(74) Representative: Frain, Timothy John

(56) References cited:
- FUJITSU-SCIENTIFIC AND TECHNICAL JOURNAL, vol. 25, no. 1, March 1989, KAWASAKI JP pages 37 - 42; A. YAMASHITA, T. NAKAMURA, T. KATOH: 'A new path memory for Viterbi decoders'
- IEEE National Telecommunications Conference 1981, vol. 3, New Orleans 29.11.81 - 03.12.81, pages E.1.7.1 - E.1.7.4; R.M. ORNDORFF et al.: "Viterbi Decoder VLSI Integrated Circuit for Bit Error Correction"

## Description

The present invention concerns a circuitry arrangement implementing the Viterbi algorithm according to the introduction of claim 1.

The Viterbi algorithm is an algorithm which is commonly used in decoding convolution codes. The Viterbi algorithm is used in receivers of digital transmission systems, for instance in general European digital mobile telephone system (GSM, Groupe Special Mobile), in which digital data to be transmitted to a radio path is on one hand encoded specifically (convolutional coding), and on the other hand, in a transmission chain (transmitter, radio channel, receiver) such mutual effect is produced, which can be processed as unintentional analogous convolutional coding. A coded data signal on the receiving side must be so indicated that the most probable transmitted bit sequence is found therein. The Viterbi algorithm may be used both for said decoding of this code and for indicating the bits of the receiver, in which the unintentional analogous convolutional code produced by the mutual effect of the transmission chain is decoded, and for decoding the channel coding (convolutional coding).

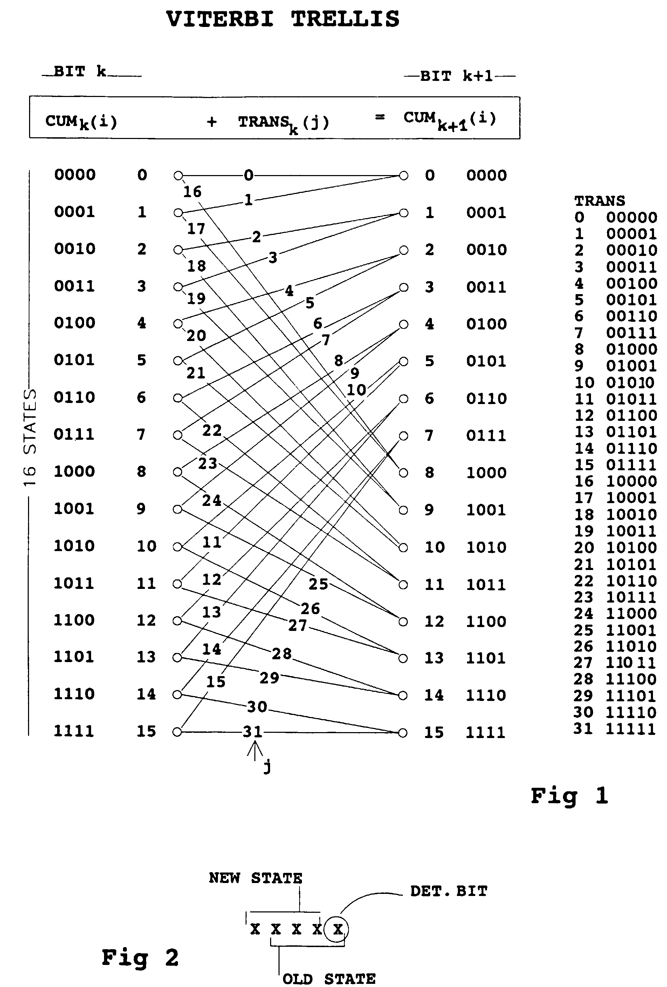

Fig. 1 presents the Viterbi-Trellis encoding known in itself in the art, which forms the basis for the present invention, and its functioning. Each received bit (BITₖ, BITₖ₊₁) includes 16 potential STATES. Each state is associated with a cumulative value CUM describing how probable, or 'good', a path is from the beginning of a bit pattern, that is, from the beginning of a given time interval, to said state. Fig. 1 also presents (within the scope of the trellis presented in this connection) the permitted transitions from one state to another. Each transition is associated with a transition value TRANS determining the 'goodness' of each transition. Each state may, in the present trellis, be entered along two alternative paths. When the cumulative values CUMₖ of the starting state of the previous bit BITₖ and the transition values TRANSₖ are added, a 'goodness value' CUMₖ₊₁ is obtained for each potential state of the next bit BITₖ₊₁, from which the 'goodness' of the bit path from the beginning of the time interval may be derived. Since 16 states may be provided and two paths may lead to each state, there may be 32 transition values j.

Fig. 2 demonstrates the states associated with each bit DET.BIT: the previous state OLD STATE and the new state NEW STATE, to which the above mentioned CUM values are related and the it-specific potential transitions wherebetween the TRANS values illustrate.

By comparing the 'goodness' of the two paths entering into each state, the better one of these may be selected. The sum of the cumulative value CUMₖ of the initial state of the selected path and of the transition value TRANSₖ is stored to be the cumulative value of the next state, that is, of a newer bit BITₖ₊₁. For each bit, 16 states i must be calculated, the cumulative values CUMₖ₍ᵢ₎ of the states thereof being stored in a trace back table (Trace Back, TB).

The conventionally above described Viterbi algorithm is implemented by circuits positioned in parallel (e.g. one circuit per each bit space, 16 parallel circuits in the present case). The great number of circuits raises the equipment cost. In addition, the great number of components for instance in the GSM mobile telephone increases the current consumption.

FUJITSU SCIENTIFIC AND TECHNICAL JOURNAL, Vol. 25, No. 1, March 1989, pages 37-42; A. YAMASHITA et al.: "A New Path Memory for Viterbi Decoders" discloses a Viterbi decoder in accordance with the preamble portion of Claim 1.

The object of the invention is to eliminate or to reduce the above adverse factors.

The present invention is defined in the appended claims.

By processing serially the data associated with each possible state of the bit being examined, or in sequence, the circuitry can be made very simple. The processing of the above described Viterbi algorithm regarding each state is carried out. 16 states are calculated in sequence for each bit, the values associated therewith being stored in a trace back table. When all bits of said time interval have been processed, the tracing of a return path is done on the basis of the stored values, whereby the potentially best path is followed from the end to the beginning. In this manner, each bit and/or the symbols related to the bits of the time interval is/are indicated.

The same circuitry may be used e.g. in the GSM mobile telephone to indicate the bit sequence of the receiver, and in addition, discharging of channel-specific decoding (channel decoding) may be accomplished. An advantage of the simple implementation is reduced current consumption, which e.g. in the battery operated GSM telephone is a remarkable advantage. The circuitry of the invention may be implemented as an integrated circuit, such as the VLSI circuit.

According to the principles of the invention, it is also feasible to implement any other Viterbi algorithm, in which a trellis such as the one presented in Fig. 1 is employed.

The invention is described below by the aid of the figures of a drawing, in which
Fig. 1 presents the operation of the known Viterbi-Trellis algorithm in table form,
Fig. 2 presents, simplifying, the state-of-art presentation principle of a bit being examined by the aid of the values associated with two states,
Fig. 3 presents the block diagram of the circuitry of the invention implementing the Viterbi algorithm in serial form, and
Fig. 4 presents the principle block diagram of the tracing of the return path.

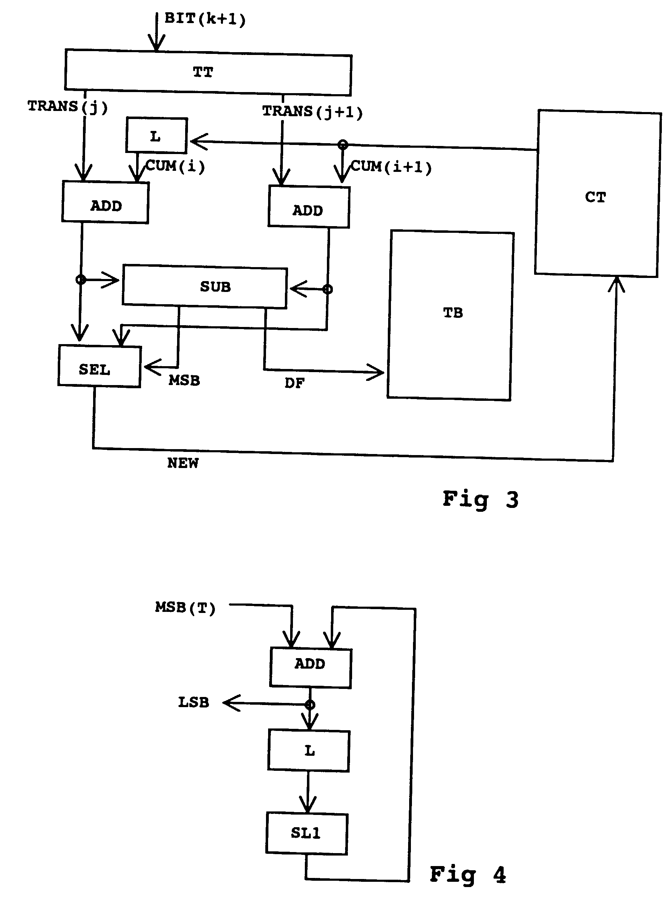

Fig. 3 presents the circuitry of the invention applicable e.g. in the presentation and/or channel decoding of the bits received in the GSM mobile telephone. As the input data for the circuitry are provided the 32 transition values TRANS(j), TRANS(j+1) connected to one bit BIT(k+1), which are shifted into the transition value table TT. The cumulative values CUM(i) of the previous bit are stored in table CT (CUM Table), from which they are carried into adders ADD; into another adder ADD through a delay circuit L (Latch). The addition of the transition values TRANS and cumulative values CUM related to each state is carried out in the adder. The sums thus obtained are compared in a subtraction unit SUB. With the aid of the most significant bit MSB of the subtraction the selector unit SEL selects a higher sum for a new cumulative value NEW, stored in the table of cumulative values CT. The difference DF of the subtraction (Difference), being scaled in a desired number of bits, is stored in the Trace Back Table TB.

All states included in a given bit are calculated in the same way sequentially, or in serial form, and the results are stored in tables CT, TB. After the calculation of one bit has been completed, the transition values associated with the next bit are read, and the same sequence is started again. The calculation is repeated for all bits of a given time interval. ('Time interval' may in the present connection mean e.g. the frame of the GSM system provided with 148 bits).

When all bits of a time interval have been processed, the tracing of the return path is carried out. Fig. 4 shows a principle block diagram of the circuitry implementing this step. The 'best' path, that is, the description of a path, is read in Table TB (Fig. 3). The topmost bit MSB(T) (the most significant bit) of the difference DF stored in Table TB is equivalent to the indicated bit, and it expresses along which path, according to the trellis, the state of the previous bit can be reached. When said topmost bit MSB(T) is summed up with the value of the state shifted to the left, the value LSB of the next state, when going backwards, is obtained, or the four least significant bits. With the LSB value the value of the next state of the return path memory following from the address location (when going backwards) is presented. In Fig. 4 the circuit L is a delay circuit, and the circuit SL1 (Shift Left One) shifts the value at each moment one bit to the left.

This procedure is repeated for each bit of a time interval, until the entire bit sequence of the time interval has been indicated. Thereafter, the processing of the bits of a next time interval is started.

## Claims

1. Circuitry implementing the Viterbi algorithm in a trellis in which each state may be entered along two alternative paths, and the states of the bits of a defined time interval are processed with the circuitry in serial form for indicating the symbol of a bit and/or several bits, the circuitry comprising
(a) addition circuits (ADD) operable, for each bit (BITₖ), to calculate addition values of each potential next state from the sum of the transition values (TRANSₖ) and the cumulative values (CUM(i)) of the states at each moment;
(b) comparison means by which the two addition values of each state are compared;
(c) a trace back path table (TB) storing the result of comparison; and
(d) a selection circuit selecting a new cumulative value (NEW) and storing it in the table of cumulative values (CT)
characterised in that
the comparison means comprises a subtraction circuit (SUB) producing a comparison result in the form of a number of bits.

2. Circuitry according to Claim 1, characterised in that it comprises furthermore
(e) an indication circuit of a return path, in which on the basis of the bit-specific data (MSBT(T)) read in the trace back path table the address (LSB) of an address location is calculated at each bit of the timer interval from which the most probable value of the bit or symbol at a moment can be read,
whereby the bits or symbols of a time interval are indicated starting from the last one.

3. A use of the circuitry according to Claim 2 for indicating the bits of a signal flow.

4. A use of the circuitry according to Claim 3 for decoding the convolutional code of a signal flow.

5. A use of a circuitry according to Claim 2 both for indicating the bits of a signal flow and for decoding the convolutional code in the same apparatus.

6. Circuitry according to Claim 1 or 2, characterised in that it is implemented as a part of an integrated circuit.

7. A use of a circuitry according to any one of Claims 1, 2 or 6 in a mobile telephone of the general European digital mobile telephone system.

## Patentansprüche

1. Schaltung zur Durchführung des Viterbi-Algorithmus in einem Gitterwerk, in dem jeder Zustand entlang zweier alternativer Pfade erreicht werden kann, wobei die Zustände der Bits eines definierten Zeitintervalls mit der Schaltunganordnung in serieller Form verarbeitet werden, um das Symbol eines Bits und/oder mehrerer Bits anzugeben, die folgendes aufweist:
(a) Addierschaltungen (ADD), die für jedes Bit (BITₖ) so betreibbar sind, daß sie Additionswerte für jeden möglichen nächsten Zustand aus der Summe der Übergangswerte (TRANSₖ) und der kumulativen Werte (CUM(i)) der Zustände in jedem Moment berechnen;
(b) eine Vergleichseinrichtung, durch die die zwei Additionswerte jedes Zustands verglichen werden;
(c) eine Zurückverfolgungspfad-Tabelle (TB), die das Vergleichsergebnis einspeichert; und
(d) eine Auswählschaltung, die einen neuen kumulativen Wert (NEW) auswählt und ihn in die Tabelle kumulativer Werte (CT) einspeichert;
**dadurch gekennzeichnet, daß** die Vergleichseinrichtung eine Subtrahierschaltung (SUB) aufweist, die ein Vergleichsergebnis in Form einer Anzahl von Bits erzeugt.

2. Schaltung nach Anspruch 1, **dadurch gekennzeichnet, daß** sie ferner folgendes aufweist:
(e) eine Angabeschaltung für einen Rückwärtspfad, in der auf Grundlage der bitspezifischen Daten (MSBT(T)), wie in die Zurückverfolgungspfad-Tabelle eingelesen, die Adresse (LSB) eines Adreßorts für jedes Bits des Timerintervalls berechnet wird, woraus der wahrscheinlichste Wert des Bits oder Symbols in einem Moment gelesen werden kann;
- wobei die Bits oder Symbole eines Zeitintervalls ausgehend vom letzten angegeben werden.

3. Verwendung der Schaltung nach Anspruch 2 zum Anzeigen der Bits eines Signalflusses.

4. Verwendung der Schaltung nach Anspruch 3 zum Decodieren des Faltungscodes eines Signalflusses.

5. Verwendung der Schaltung nach Anspruch 2, sowohl zum Anzeigen der Bits eines Signalflusses als auch zum Decodieren des Faltungscodes in derselben Vorrichtung.

6. Schaltung nach einem der Ansprüche 1 oder 2, **dadurch gekennzeichnet, daß** sie als Teil einer integrierten Schaltung realisiert ist.

7. Verwendung einer Schaltung nach einem der Ansprüche 1, 2 oder 6 in einem Mobiltelefon gemäß dem allgemeinen Europäischen Digitalen Mobiltelefonsystem.

## Revendications

1. Circuit mettant en oeuvre l'algorithme de Viterbi dans un treillis dans lequel chaque état peut être entré suivant deux chemins alternés et les états des bits d'un intervalle de temps défini sont traités avec les circuits sous forme série pour indiquer le symbole d'un bit et/ou de nombreux bits, les circuits comprenant :
(a) des circuits d'addition (ADD) mis en oeuvre pour chaque bit (BITₖ), pour calculer les valeurs d'addition de chaque état potentiel suivant à partir de la somme des valeurs de transition (TRANSₖ) et des valeurs cumulatives (CUM(i)) des états à chaque moment ;
(b) un moyen de comparaison grâce auquel les deux valeurs d'addition de chaque état sont comparées ;
(c) une table d'analyse récursif (TB) mémorisant le résultat de la comparaison ; et
(d) un circuit de sélection sélectionnant une nouvelle valeur cumulative (NOUVELLE) et la mémorisant dans la table des valeurs cumulatives (CT)
Caractérisé en ce que
le moyen de comparaison comprend un circuit de soustraction (SUB) produisant un résultat de comparaison sous la forme d'un certain nombre de bits.

2. Circuit selon la revendication 1, caractérisé en ce qu'il comprend de plus
(e) un circuit d'indication d'un chemin de retour, dans lequel sur la base de données spécifiques au bit (MSBT(T)) extrait de la table d'analyse récursif, l'adresse (LSB) d'un emplacement d'adresse est calculée à chaque bit de l'intervalle de temps à partir duquel la valeur la plus probable du bit ou du symbole à un moment peut être extraite,
d'où il résulte que les bits ou symboles d'un intervalle de temps sont indiqués en commençant à partir du dernier.

3. Utilisation des circuits selon la revendication 2 pour indiquer les bits d'un flux de signaux.

4. Utilisation des circuits selon la revendication 3 pour décoder le code à convolution d'un flux de signaux.

5. Utilisation des circuits selon la revendication 2 pour à la fois indiquer les bits d'un flux de signaux et pour décoder le code à convolution dans le même appareil.

6. Circuit selon la revendication 1 ou 2, caractérisé en ce qu'il est mis en oeuvre comme une partie d'un circuit intégré.

7. Utilisation d'un circuit selon l'une quelconque des revendications 1, 2 ou 6 dans un téléphone mobile du système de téléphone mobile numérique Européen général.
